(19) Europäisches Patentamt
European Patent Office
Office européen des brevets

(11) **EP 1 402 575 B1**

(12) **EUROPÄISCHE PATENTSCHRIFT**

(45) Veröffentlichungstag und Bekanntmachung des Hinweises auf die Patenterteilung:
**12.11.2008 Patentblatt 2008/46**

(21) Anmeldenummer: **02745398.4**

(22) Anmeldetag: **20.06.2002**

(51) Int Cl.:
*H01L 25/065* *(2006.01)*     *H01L 23/48* *(2006.01)*

(86) Internationale Anmeldenummer:
**PCT/EP2002/006861**

(87) Internationale Veröffentlichungsnummer:
**WO 2003/001597 (03.01.2003 Gazette 2003/01)**

(54) **VERTIKAL KONTAKTIERTE, ÜBEREINANDER GESTAPELTE CHIPS**

VERTICALLY CONTACTED STACKED CHIPS

PUCES EMPILEES MISES EN CONTACT VERTICALEMENT

(84) Benannte Vertragsstaaten:
**AT BE CH CY DE DK ES FI FR GB GR IE IT LI LU MC NL PT SE TR**

(30) Priorität: **21.06.2001 DE 10130864**

(43) Veröffentlichungstag der Anmeldung:
**31.03.2004 Patentblatt 2004/14**

(73) Patentinhaber: **Giesecke & Devrient GmbH**
**81677 München (DE)**

(72) Erfinder: **GRASSL, Thomas**
**85354 Freising (DE)**

(56) Entgegenhaltungen:
WO-A-99/49509          DE-A- 10 049 551
DE-C- 4 314 907          DE-C- 19 702 121
US-A- 5 424 589          US-A- 5 654 564

• PATENT ABSTRACTS OF JAPAN vol. 011, no. 041 (E-478), 6. Februar 1987 (1987-02-06) & JP 61 206249 A (HITACHI LTD), 12. September 1986 (1986-09-12)

**Beschreibung**

Die vorliegende Erfindung betrifft eine dreidimensionale Halbleiterschaltungsanordnung mit übereinander angeordneten, vertikal miteinander elektrisch leitend verbundenen Chips und insbesondere die elektrische Kontaktierung mindestens eines elektronischen Bauelements einer oberen Chiplage mit mindestens einem elektronischen Bauelement einer darunter liegenden Chiplage.

Aufgrund der begrenzten Zahl möglicher Verbindungen zwischen einzelnen, nebeneinander angeordneten Chips und die durch weit verzweigte Leiterbahnen und hohen Leistungsverbrauch der Interface-Schaltungen begrenzte Geschwindigkeit solcher Chipverbindungen werden Chips zunehmend übereinander angeordnet und vertikal elektrisch leitend miteinander verbunden. Die Interchip-Verbindungen sind kurz und widerstandsarm, so daß die Signalübermittlungsgeschwindigkeit hoch ist.

Verfahren zur Herstellung dreidimensionaler ICs durch Übereinanderstapeln und vertikales Kontaktieren mehrerer Chips werden beispielsweise in DE 4314 907 C1 und DE 197 02121 C1 beschrieben. Jede Halbleiterschaltungsschicht bzw. jede Chiplage der dreidimensionalen Halbleiterschaltungsanordnung umfaßt eine Substratschicht als untere Schicht und darauf eine obere Schicht umfassend Schichtfolgen aus Metallisierungsschichten und dielektrischen Zwischenschichten einschließlich aktiven elektronischen Bauelementen, Leiterbahnen und Kontakten, über die die aktiven Elemente mit externen Anschlüssen oder mit Kontakten einer darunter oder darüber angeordneten Chiplage des dreidimensionalen ICs elektrisch leitend verbunden werden.

Gemäß der DE 43 14 907 C1 wird ein oberer Chip mit einem darunterliegenden Chip mittels vertikalen Anschlußverbindungen elektrisch leitend verbunden, indem ein aus der Unterseite des oberen Chips herausragender Metallstift durch eine Öffnung in einer Planarisierungsschicht des unteren Chips auf eine in der Öffnung liegende Kontaktfläche des unteren Chips aufgesetzt wird. Die Kontaktfläche des unteren Chips besteht aus einem leicht schmelzbaren Material, beispielsweise AuIn, und durch Anpressen des oberen Chips und Erwärmen der Kontaktfläche wird ein dauerhafter Kontakt zwischen dem Metallstift des oberen Chips und der Kontaktfläche des unteren Chips hergestellt. Aufgrund von Justierungsungenauigkeiten beim Übereinanderstapeln der Chips müssen die Kontaktfläche des unteren Chips und die darüberliegende Öffnung in der Planarisierungsschicht ausreichend groß gewählt werden, damit der Metallstift des oberen Chips die Kontaktfläche des unteren Chips in jedem Falle trifft.

In der DE 192 02121 C1 ist eine ähnliche vertikale Chipverbindung zwischen einer Kontaktfläche eines unteren Chips und einem aktiven Bauelement des oberen Chips beschrieben. Bei dem dort beschriebenen Verfahren wird ein oberer Chip zunächst mittels einer Kleberschicht fest auf dem unteren Chip fixiert, nachdem die angrenzende Oberfläche des unteren Chips mittels einer Passivierungsschicht absolut eben gemacht wurde. Der obere Chip besitzt im Bereich der Kontaktfläche des unteren Chips eine vertikale Durchgangsöffnung, die entweder vor oder nach dem Verbinden der beiden Chips in dem oberen Chip erzeugt wurde. Die Innenwand dieser Durchgangsbohrung wird zunächst mit einer Siliziumoxidschicht bedeckt, die Passivierungsschicht des darunterliegenden Chips wird dann im Bereich der Durchgangsöffnung bis zu der Kontaktfläche des unteren Chips weggeätzt und die Durchgangsbohrung wird sodann mit elektrisch leitendem Material aufgefüllt, um eine vertikale, elektrisch leitende Verbindung zwischen einem Bauelement des oberen Chips und der Kontaktfläche des unteren Chips zu erzeugen. Auch bei diesem Verfahren ist es wichtig, daß die Kontaktfläche des unteren Chips groß ist, damit die Durchgangsbohrung trotz etwaiger Justierungsungenauigkeiten beim Übereinanderstapeln der Chips in jedem Falle über der Kontaktfläche des jeweils darunterliegenden Chips zu liegen kommt.

Dokument DE 100 49 551 beschreibt einen Halbleiterchip, der zum Aufbauen einer dreidimensionalen Halbleiterschaltungsanordnung vorgesehen ist. Er verfügt über eine ihn durchdringende Durchgangselektrode, eine Kontakthöckerelektrode auf seiner Vorderseite und eine Kontaktfleckelektrode auf seiner Rückseite sowie über Verdrahtungsmuster auf seiner Vorder- bzw. Rückseite zum selektiven Verbinden der Kontakthöckerelektrode und der Kontaktfleckelektrode über die Durchgangselektrode.

Durch Aufstapeln derartiger Halbleiterchips wird die auf einem unteren Halbleiterchip ausgebildete Kontakthöckerelektrode stumpf an eine auf einem oberen Halbleiterchip ausgebildete Kontaktfleckelektrode angesetzt, wodurch der untere und der obere Halbleiterchip miteinander verbunden werden.

Die vorgenannten dreidimensionalen ICs haben somit den Nachteil, daß die Kontaktflächen zur vertikalen Interchip-Kontaktierung wegen der Justierungenauigkeiten von beispielsweise $\pm$ 10 $\mu$m beim Stapeln der Chips vergleichsweise groß sein müssen, beispielsweise 20 $\mu$m x 20 $\mu$m, damit eine Kontaktierung in jedem Falle gewährleistet ist. Aufgrund der geringen Dicke der übereinander gestapelten Chips von weniger als 20 $\mu$m verursachen die großen Interchip-Kontaktflächen ein unerwünschtes Übersprechen zwischen den Metallisierungen der verschiedenen Chips und der Interchip-Kontaktfläche. Außerdem sind aufgrund der großen Interchip-Kontaktflächen sehr große und starke Treiber mit einem entsprechend hohen Leistungsverbrauch erforderlich, was den grundsätzlichen Zielen des Chip-Designs entgegenläuft. Schließlich wirken große Interchip-Kontaktflächen als vergleichsweise leistungsstarke Flächenstrahler mit elektromagnetischer Abstrahlcharakteristik, so daß die über die Interchip-Kontaktflächen übertragenen Informationen vergleichsweise einfach detektierbar sind, was bei der Übermittlung sicherheitsrelevanter Signale, beispielsweise in Chipkarten, kritisch ist.

Die Problematik des Übersprechens erfordert darüber hinaus ein sehr sorgfältiges Chip-Design und die Durchführung von Experimenten, um sicherzustellen, daß die funktionalen Bauteile der Chips durch ein Übersprechen der Signale nicht beeinflußt werden. Diese experimentelle Überprüfung gestaltet sich um so schwieriger, je größer die Justierungenauigkeiten beim Übereinanderstapeln der Chips sein können. Aus diesem Grunde müssen die Spezifikationen von Interchip-Verbindungen entsprechend weit gefaßt werden, das heißt, die Interchip-Kontaktflächen von den elektronischen Bauteilen und Leitungen angrenzender Chips möglichst weit entfernt untergebracht werden. Ohne solche Restriktionen könnten die Chips wesentlich kleiner gestaltet werden.

Aufgabe der vorliegenden Erfindung ist es daher, eine Halbleiterschaltungsanordnung aus übereinander angeordneten, vertikal miteinander elektrisch leitend verbundenen Halbleiterbauelementen mit verbessertem Übersprechverhalten der Interchip-Verbindung zu schaffen.

Diese Aufgabe wird erfindungsgemäß durch eine Halbleiterschaltungsanordnung mit den Merkmalen des Patentanspruchs 1 gelöst. In davon abhängigen Ansprüchen sind vorteilhafte Ausgestaltungen und Weiterbildungen der Erfindung angegeben.

Dementsprechend ist die Interchip-Kontaktfläche von beispielsweise 20 $\mu$m x 20 $\mu$m Größe in einzelne Kontaktflächenbereiche rasterförmig unterteilt, deren jeweilige Größe vorzugsweise in etwa der Größe des Kontaktelements des darüberliegenden Chips entspricht oder geringfügig größer ist. Ist beispielsweise das Kontaktelement der oberen Chiplage entsprechend der Lehre der DE 43 14 907 C1 als Metallstift ausgebildet und besitzt einen Durchmesser von beispielsweise 1 $\mu$m, so ist die Interchip-Kontaktfläche der darunterliegenden Chiplage in Kontaktflächenbereiche von vorzugsweise 1 $\mu$m x 1 $\mu$m Größe mit einem Abstand zwischen den Kontaktflächenbereichen von beispielsweise 0,5 $\mu$m ausgebildet. Das Kontaktelement der oberen Chiplage kontaktiert somit unabhängig von etwaigen Justierungsungenauigkeiten mindestens einen Kontaktflächenbereich und maximal vier Kontaktflächenbereiche der Kontaktfläche der unteren Chiplage. Durch eine geeignete elektronische Ansteuerung, beispielsweise mittels Auswahltransistoren, werden dann lediglich diejenigen Kontaktflächenbereiche "aktiv" geschaltet, die tatsächlich von dem Kontaktelement der oberen Chiplage kontaktiert sind. Die übrigen Kontaktflächenbereiche sind hierbei "inaktiv". An ihnen liegt keinerlei Potential an, so daß sie auch nicht abstrahlen. Aufgrund der kleineren effektiven Kontaktfläche, die durch die aktiven Kontaktflächenbereiche gebildet wird, benötigt die Interchip-Verbindung insgesamt weniger Leistung, so daß auf zusätzliche leistungsstarke Treiber verzichtet werden kann. Auch das Übersprechverhalten wesentlich verbessert.

Ein besonderer Vorteil ergibt sich insbesondere dann, wenn zahlreiche elektronische Bauelemente einer oberen Chiplage über entsprechend zahlreiche Interchip-Verbindung mit zugehörigen elektronischen Bauelementen einer unteren Chiplage elektrisch leitend zu verbinden sind. Dies ist beispielsweise der Fall für ein Bildaufnehmer-Array in einem CMOS-Kamerachip, bei dem sich die Bildaufnehmer in einer oberen Chiplage befinden und jeder Bildaufnehmer jeweils mit einer zugehörigen Auswerteschaltung in einer darunterliegenden Chiplage elektrisch leitend verbunden wird. Würde gemäß dem Stand der Technik jede Interchip-Kontaktfläche der unteren Chiplage mit beispielsweise 20 $\mu$m x 20 $\mu$m dimensioniert, um Justierungenauigkeiten in jedem Falle zu erfassen, so ergäbe sich für ein Kontaktflächen-Array von 4 x 4 Interchip-Kontaktflächen eine Gesamtkontaktflächengröße von mehr als 80 $\mu$m x 80 $\mu$m. Die erfindungsgemäße rasterartige Auflösung der Kontaktflächen in Kontaktflächenbereiche von beispielsweise 1 $\mu$m x 1 $\mu$m (für einen Durchmesser des Kontaktelements der oberen Chiplage von 1 $\mu$m), so reduziert sich die Gesamtkontaktfläche auf eine Größe von etwas mehr als 8 $\mu$m x 8 $\mu$m (vier Kontaktflächenbereiche je Kontaktelement) zuzüglich einem $\mu$m-gebenden Toleranzbereich zum Ausgleich von Justierungenauigkeiten von 10 $\mu$m Breite, das heißt insgesamt auf etwas mehr als 28 $\mu$m x 28 $\mu$m Gesamtkontaktfläche. Die Gefahr eines Übersprechens auf Metallisierungen der angrenzenden Chips wird dadurch auf eine kleinere Fläche reduziert.

Nachfolgend wird die Erfindung beispielhaft anhand der begleitenden Zeichnungen dargestellt. Darin zeigen:

Fig.1    einen Ausschnitt aus einem dreidimensionalen IC umfassend zwei Chiplagen mit erfindungsgemäßen Interchip-Kontaktflächenbereichen;

Fig. 2    eine prinzipielle Darstellung der Aktivierung einzelner, kontaktierter Interchip-Kontaktflächenbereiche;

Fig. 3    ein Kontaktflächen-Array nach dem Stand der Technik; und

Fig. 4    ein Kontaktflächen-Array gemäß der vorliegenden Erfindung.

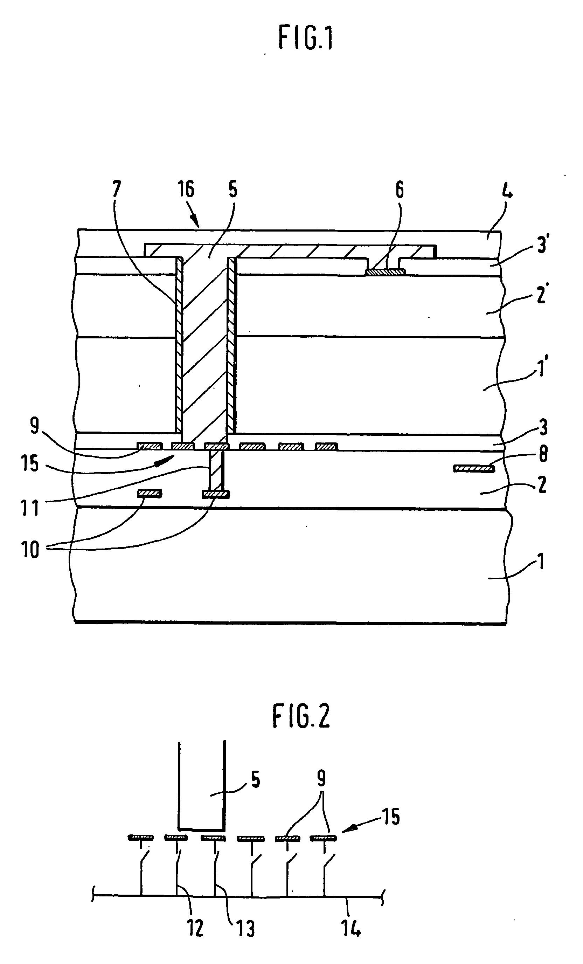

Fig.1 zeigt einen Teil einer vertikalen Halbleiterschaltungsanordnung umfassend zwei Chiplagen im Schnitt. Lediglich diejenigen Bestandteile der Anordnung, welche keine durchgehenden Schichten bilden, sind schraffiert dargestellt. Die in Fig.1, prinzipiell dargestellte Anordnung kann nach dem Verfahren der eingangs erwähnten DE 197 02121 C1 erzeugt werden. Nachfolgend wird daher nur in aller Kürze der Aufbau dieser Halbleiterschaltungsanordnung beschrieben. Die untere Chiplage und die obere Chiplage umfassen jeweils eine Substratschicht 1 bzw.1', eine darüber-liegende Schicht 2 bzw. 2' mit Metallisierungsschichten, dielektrischen Zwischenschichten und aktiven Elementen 8 sowie eine Passivierungsschicht 3 bzw. 3', mit denen die Kontaktflächen 15 bzw. 6 der oberen Schichten 2 bzw. 2' passiviert und die Oberflächen der einzelnen Chiplagen eben ausgebildet sind. Eine Durchgangsöffnung 16 in der oberen Chiplage 1' bis 3', welche sich bis in die Passivierungsschicht 3 der unteren Chiplage erstreckt, ist mit elektrisch leitfähigem Material aufgefüllt, welches sich über die Oberfläche der Passivierungsschicht 3' der oberen Chiplage bis zur Kontaktfläche 6 eines Halbleiterbauelements der oberen Chiplage erstreckt. Dieses elektrisch leitfähige Material dient als elektrisch leitendes Verbindungselement 5 zwischen der Kontaktfläche 6 der oberen Chiplage und der Kontaktfläche 15 der unteren Chiplage. Das Verbindungselement 5 ist in der Durchgangsöffnung 16 von einer Distanzschicht 7 aus Siliziumoxid umgeben und ist über der Passivierungsschicht 3' mit einer weiteren Passivierungsschicht 4' abgedeckt.

Die Kontaktfläche 15 wird durch mehrere kleine Kontaktflächenbereiche 9 gebildet. Wie Fig.1 zu entnehmen ist, kontaktiert das elektrisch leitende Verbindungselement 5 lediglich einzelne Kontaktflächenbereiche 9 der Kontaktfläche 15. Nur diese tatsächlich kontaktierten Kontaktflächenbereiche 9 werden aktiv geschaltet, so daß die nicht kontaktierten Kontaktflächenbereichen 9 keine Verbindung zum Verbindungselement 5 haben.

Dies ist in Fig. 2 schematisch dargestellt. Mittels Transistoren 12, 13 werden lediglich diejenigen Kontaktflächenbereiche 9 elektrisch leitend mit der Leiterbahn 14 verbunden, die von dem elektrisch leitenden Verbindungselement 5 kontaktiert sind. Fig.en 1 und 2 ist desweiteren zu entnehmen, daß das elektrisch leitende Verbindungselement 5 so dimensioniert ist, daß es maximal zwei benachbarte Kontaktflächenbereiche 9 kontaktiert. Dadurch wird sichergestellt, daß mindestens ein Kontaktflächenbereich 9 und, bei geeigneter zweidimensionaler Array-Anordnung der Kontaktflächen-bereiche 9, maximal vier Kontaktflächenbereiche 9 kontaktiert sind.

Das "Aktiv"-Schalten der tatsächlich kontaktierten Kontaktflächenbereiche 9 kann mittels einer einfachen Ansteuerlogik, beispielsweise mittels Auswahltransistoren, erfolgen. Die Auswahllogikschaltung kann in den Treibern der Interchip-Verbindungen integriert sein und/oder unter den Kontaktflächenbereichen 9 liegen. Letzteres ist in Fig.1 dargestellt, wo Auswahlansteuerungseinrichtungen 10 unterhalb der Kontaktflächenbereiche 9 liegen und lediglich diejenige elektrische Verbindung 11 "aktiv" geschaltet ist, welche von dem elektrisch leitenden Verbindungselement 5 kontaktiert ist.

Geeignete elektronische Schalter sind allgemein und in vielfältigen, unterschiedlichen Ausführungen bekannt und beispielsweise in US 5,424,589, insbesondere in Fig.en 6a bis 6c mit zugehöriger Beschreibung Spalte 17, Zeile 27 bis Spalte 18, Zeile 14 beschrieben. Auf die Offenbarung der US 5,424,589 wird hiermit Bezug genommen.

Die Auswahlschaltung kann vorteilhafter Weise erweitert werden, um die Kontaktierung der Interchip-Verbindungen zu testen und einen Zuverlässigkeitstest durchzuführen.

Eine in den Fig. nicht dargestellte komfortablere Auswahlschaltung kann nicht nur einzelne Kontaktflächenbereiche 9 zu einer Leiterbahn 14 verbinden oder sperren. Zusätzlich ist hierbei (beispielsweise durch parallele, unabhängig.ansteuerbare Schalter) eine wahlweise Verbindung zu einer von mehreren Leiterbahnen 14 schaltbar. Eine solche Anordnung ist insbesondere für gattungsgemäße Halbleiterschaltungsanordnungen mit vielen Interchip-Verbindungen vorteilhaft, weil dadurch bei gleicher Montagetoleranz benachbarte, mit einzelnen Verbindungselementen 5 verbindbare Kontaktflächen 15 überlappen können und somit ein geringerer Gesamtkontaktflächenbedarf erreicht wird. In einem solchen Fall werden die tatsächlichen Verbindungen von Kontaktflächen 9 und Verbindungselementen 5 nach der Montage durch Testen ermittelt und daraufhin die Auswahlschaltung festgelegt.

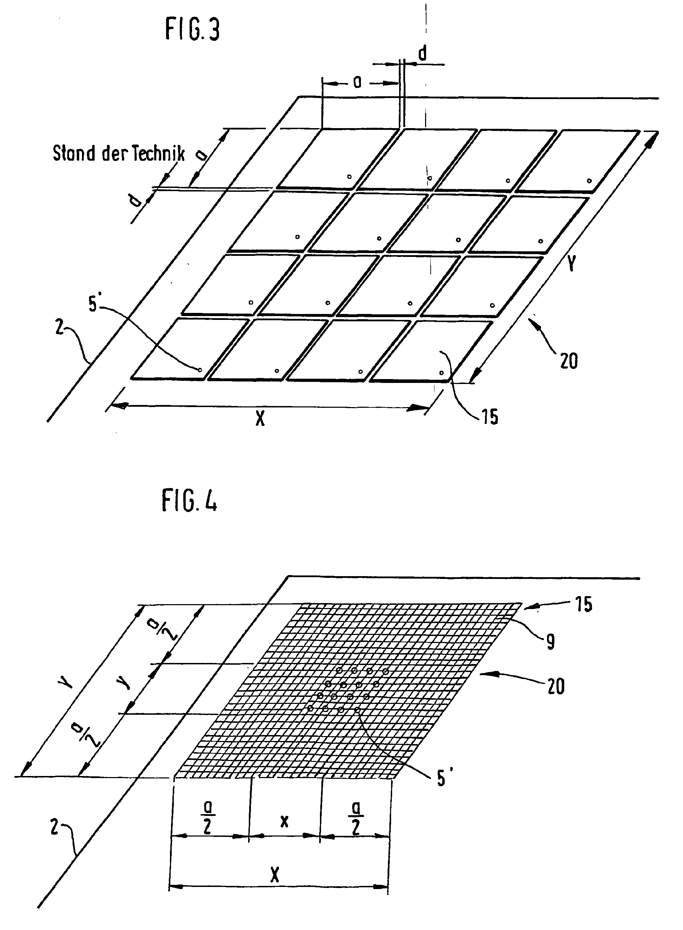

Besonders vorteilhaft ist die Erfindung im Zusammenhang mit größeren Kontaktflächen-Arrays anwendbar und wird nachfolgend am Beispiel eines CMOS-Kamerachips erläutert. Fig. 3 zeigt ein Kontaktflächen-Array 20 auf der Oberfläche einer Schicht 2 einer unteren Chiplage. Jeder Kontaktfläche 15 ist ein Bildaufnehmer in einer darüberliegenden, in Fig. 3 nicht dargestellten Chiplage sowie eine (nicht dargestellte) Auswerteschaltung in der unteren Chiplage zugeordnet. Aufgrund möglicher Justierungenauigkeiten beim Aufeinanderstapeln der einzelnen Chiplagen sind die Kantenlängen a der einzelnen Kontaktflächen 15 vergleichsweise groß und betragen beispielsweise 20 $\mu$m x 20 $\mu$m. Dadurch wird eine Justierungenauigkeit von etwa $\pm$ 10 $\mu$m erfaßt. Die Kontaktflächen 15 sind in einem Abstand d von beispielsweise 0,5 $\mu$m angeordnet. Die Gesamtabmessung des Kontaktflächen-Arrays 20 beträgt somit

$$X = Y = z * a + (z\text{-}1) * d,$$

wobei z die Anzahl der Kontaktflächen 15, a die Kantenlänge einer Kontaktfläche 15 und d der Abstand zwischen den Kontaktflächen 15 bezeichnen. Mit a = 20 $\mu$m und d = 0,5 $\mu$m ergibt sich dann

$$X = Y = 81,5 \ \mu m,$$

für ein 4x4-Kontaktflächen-Array 20 (z = 4) gemäß dem Stand der Technik. Die Stellen, an denen die Kontaktflächen 15 von dem (nicht dargestellten) elektrisch leitenden Verbindungselement 5 der darüberliegenden Chiplage kontaktiert werden, sind in Fig. 3 als Kontaktierungsstellen 5' gekennzeichnet und liegen aufgrund von Justierungsungenauigkeiten beim Stapeln der Chiplagen versetzt zum jeweiligen Kontaktflächenmittelpunkt.

In Fig. 4 ist ein dem Kontaktflächen-Array 20 aus Fig. 3 entsprechendes Kontaktflächen-Array 20 gemäß einer bevorzugten Ausführungsform der vorliegenden Erfindung dargestellt. Demnach wird eine Kontaktfläche 15 durch vier Kontaktflächenbereiche 9 gebildet, da davon auszugehen ist, daß die Kontaktierungsstelle 5', deren Abmessungen in etwa den Abmessungen eines Kontaktflächenbereichs 9 entspricht, nur in Ausnahmefällen exakt auf ein oder gegebenenfalls zwei benachbarte Kontaktflächenbereiche 9 trifft. Legt man wiederum für die Kontaktierungsstelle 5' einen Durchmesser von 1 $\mu$m zugrunde und dimensioniert man dementsprechend jeden Kontaktflächenbereich 9 als eine 1 $\mu$m x 1 $\mu$m große Fläche, so hat eine aus vier Kontaktflächenbereichen 9 gebildete Kontaktfläche 15 eine Kantenlänge von zweimal 1 $\mu$m + 0,5 $\mu$m Abstand, also insgesamt 2,5 $\mu$m x 2,5 $\mu$m. Ein Array von vier Kontaktflächen 15 besitzt dementsprechend die Abmessungen:

$$x = y = z * 1 \, \mu m + (z - 1) * 0{,}5 \, \mu m = 11{,}5 \, \mu m.$$

Fig. 4 zeigt ein solches aus 4 x 4 Kontaktflächen 15 gebildetes Kontaktflächen-Array in zentraler Lage des größeren Kontaktflächen-Arrays 20 für ideale Verhältnisse, wenn die übereinander angeordneten Chiplagen ideal zueinander justiert sind. Um eine Justierungenauigkeit von a/2= $\pm$ 10 $\mu$m, das heißt eine Verschiebung des 4 x 4 Arrays nach oben, unten, rechts und/oder links um 10 $\mu$m zu erfassen, ist das größere Kontaktflächen-Array 20 in jede Richtung um 10 $\mu$m gegenüber dem zentralen 4x4-Array erweitert. Die Gesamtabmessungen des Kontaktflächen-Arrays 20 betragen somit

$$X = Y = a/2 + x + a/2 = a + x$$

mit

$$X = 2 * z * 1 \, \mu m + (z - 1) * d = 9{,}5 \, \mu m$$

zu

$$X = Y = 29{,}5 \, \mu m,$$

wobei die Anzahl der Kontaktierungsstellen 5' z = 4, die Justierungenauigkeit a/2 = 10 und der Abstand d zwischen den Kontaktflächenbereichen als d = 0,5 angenommen wurden.

Ein Vergleich der Gesamtabmessungen gemäß Fig. 3 von 81,5 $\mu$m und Fig. 4 von 29,5 $\mu$m zeigt, daß die Gesamtfläche der Interchip-Kontaktflächen mittels der vorliegenden Erfindung drastisch reduziert werden kann. Je größer die Anzahl der Kontaktflächen 15 des Kontaktflächen-Arrays 20 ist, desto stärker wirkt sich dieser Effekt aus. Dadurch wird es möglich, die Interchip-Kontaktflächen in dem Chipaufbau in einen relativ kleinen Bereich zu verlagern, in dem die Gefahr des Übersprechens auf benachbarte elektrische Bauelemente gering ist. Vorzugsweise sind in diesem Bereich keinerlei sonstige elektronische Bauelemente in dem dreidimensionalen Aufbau vorgesehen.

Mittels einer geeigneten Auswahlschaltung werden dann die von einem Verbindungselement 5 kontaktierten Kontaktflächenbereiche 9, also jeweils maximal vier Kontaktflächenbereiche 9, aktiv geschaltet und elektrisch leitend mit dem diesem Verbindungselement zugeordneten elektronischen Bauelement der unteren Chiplage verbunden.

**Patentansprüche**

1. Dreidimensionale Halbleiterschaltungsanordnung mit mindestens einer ersten Chiplage (1, 2, 3) und mindestens einer zweiten Chiplage (1', 2', 3'), die übereinander angeordnet und vertikal miteinander elektrisch leitend verbunden sind, wobei mindestens ein elektronisches Bauelement der ersten Chiplage mit mindestens einem elektronischen Bauelement der zweiten Chiplage elektrisch leitend verbunden ist, indem ein mit dem elektronischen Bauelement der zweiten Chiplage elektrisch leitend verbundenes Verbindungselement (5) eine mit dem elektronischen Bauelement der ersten Chiplage elektrisch leitend verbundene Kontaktfläche (15) der ersten Chiplage kontaktiert, **dadurch gekennzeichnet, daß** die Kontaktfläche (15) der ersten Chiplage aus mehreren, elektrisch voneinander isolierten Kontaktflächenbereichen (9) besteht und eine Einrichtung vorgesehen ist, mit der diejenigen Kontaktflächenbereiche (9) elektrisch leitend mit dem elektronischen Bauteil der ersten Chiplage verbunden werden, die von dem elektrisch leitenden Verbindungselement (5) der zweiten Chiplage kontaktiert sind.

2. Halbleiterschaltungsanordung nach Anspruch 1, wobei das elektrisch leitende Verbindungselement (5) der zweiten Chiplage durch die zweite Chiplage vertikal hindurchführt.

3. Halbleiterschaltungsanordnung nach Anspruch 1 oder 2, wonach der Kontaktbereich, mit dem das elektrisch leitende Verbindungselement (5) an die Kontaktfläche (15) angrenzend, in etwa gleich der oder geringfügig kleiner ist als die Fläche eines Kontaktflächenbereichs (9) der Kontaktfläche (15).

4. Halbleiterschaltungsanordnung nach einem der Ansprüche 1 bis 3, wobei die Kontaktflächenbereiche (9) die Größe von etwa 1 $\mu$m$^2$ besitzen.

5. Halbleiterschaltungsanordnung nach einem der Ansprüche 1 bis 4, wobei die Kontaktflächenbereiche (9) ein zweidimensionales Kontaktflächen-Array (20) bilden.

6. Halbleiterschaltungsanordnung nach Anspruch 5, wobei das Kontaktflächen-Array (20) der ersten Chiplage von mehreren, jeweils separaten elektronischen Bauelementen der ersten Chiplage zugeordneten, elektrisch leitenden Verbindungselementen (5) der zweiten Chiplage kontaktiert ist und eine Auswahlschaltung vorgesehen ist, um die von einem elektrisch leitenden Verbindungselement (5) kontaktierten Kontaktflächenbereiche (9) elektrisch leitend mit dem demjeweiligen Verbindungselement (5) zugeordneten elektronischen Bauelement der ersten Chiplage zu verbinden.

**Claims**

1. A three-dimensional semiconductor circuit configuration having at least one first chip layer (1, 2, 3) and at least one second chip layer (1', 2', 3') that are stacked and vertically interconnected electrically, at least one electronic component of the first chip layer being electrically connected with at least one electronic component of the second chip layer by a connecting element (5) electrically connected with the electronic component of the second chip layer contacting a contact surface (15) of the first chip layer electrically connected with the electronic component of the first chip layer, **characterized in that** the contact surface (15) of the first chip layer consists of a plurality of mutually insulated contact surface areas (9) and a device is provided for electrically connecting with the electronic component of the first chip layer those contact surface areas (9) contacted by the electrically connecting element (5) of the second chip layer.

2. A semiconductor circuit configuration according to claim 1, wherein the electrically connecting element (5) of the second chip layer leads vertically through the second chip layer.

3. A semiconductor circuit configuration according to claim 1 or 2, wherein the contact area with which the electrically connecting element (5) adjoins the contact surface (15) is roughly equal to, or slightly smaller than, the surface of a contact surface area (9) of the contact surface (15).

4. A semiconductor circuit configuration according to any of claims 1 to 3, wherein the contact surface areas (9) have the size of about 1 square micron.

5. A semiconductor circuit configuration according to any of claims 1 to 4, wherein the contact surface areas (9) form a two-dimensional contact surface array (20).

6. A semiconductor circuit configuration according to claim 5, wherein the contact surface array (20) of the first chip layer is contacted by a plurality of electrically connecting elements (5) of the second chip layer each associated with separate electronic components of the first chip layer, and a selection circuit is provided for electrically connecting the contact surface areas (9) contacted by an electrically connecting element (5) with the electronic component of the first chip layer associated with the particular connecting element (5).

## Revendications

1. Disposition tridimensionnelle de circuit à semi-conducteur comportant au moins une première couche de puce (1, 2, 3) et au moins une deuxième couche de puce (1', 2', 3') qui sont disposées l'une au dessus de l'autre et connectées électriquement verticalement entre elles, au moins un composant électronique de la première couche de puce étant connecté électriquement avec au moins un composant électronique de la deuxième couche de puce, cette connexion ayant lieu par le fait qu'un élément de raccord (5) connecté électriquement avec le composant électronique de la deuxième couche de puce entre en contact avec une surface (15) de contact de la première couche de puce connectée électriquement avec le composant électronique de la première couche de puce, **caractérisée en ce que** la surface (15) de contact de la première couche de puce consiste en plusieurs zones (9) de surface de contact isolées électriquement les unes par rapport aux autres et **en ce qu'**une installation est prévue, par laquelle les zones (9) de surface de contact étant en contact avec l'élément de raccord (5) électroconducteur de la deuxième couche de puce sont connectées électriquement avec le composant électronique de la première couche de puce.

2. Disposition de circuit à semi-conducteur selon la revendication 1, l'élément de raccord (5) électroconducteur de la deuxième couche de puce passant verticalement à travers la deuxième couche de puce.

3. Disposition de circuit à semi-conducteur selon la revendication 1 ou 2, la zone de contact par laquelle l'élément de raccord (5) électroconducteur est adjacent à la surface (15) de contact étant à peu près de même grandeur ou légèrement plus petite que la surface d'une zone (9) de surface de contact de la surface (15) de contact.

4. Disposition de circuit à semi-conducteur selon une des revendications de 1 à 3, les zones (9) de surface de contact ayant une grandeur d'environ 1 $\mu m^2$.

5. Disposition de circuit à semi-conducteur selon une des revendications de 1 à 4, les zones (9) de surface de contact constituant un groupement (20) de surfaces de contact bidimensionnel.

6. Disposition de circuit à semi-conducteur selon la revendication 5, le groupement (20) de surfaces de contact de la première couche de puce étant en contact par plusieurs éléments de raccord (5) électroconducteurs de la deuxième couche de puce affectés respectivement à des composants électroniques de la première couche de puce séparés les uns des autres, et un circuit sélecteur étant prévu afin de connecter électriquement avec le composant électronique de la première couche de puce affecté à l'élément de raccord (5) respectif les zones (9) de surface de contact étant en contact par un élément de raccord (5) électroconducteur.

# FIG.1

# FIG.2

FIG. 3

Stand der Technik

FIG. 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4314907 C1
- DE 19702121 C1
- DE 19202121 C1
- DE 10049551
- US 5424589 A